# EUROPÄISCHE PATENTSCHRIFT

(11) **EP 2 997 658 B1**
(45) Veröffentlichungstag und Bekanntmachung des Hinweises auf die Patenterteilung: **08.03.2017**
(21) Anmeldenummer: 14720954.8
(22) Anmeldetag: 28.04.2014
(51) Int. Cl.: H03K 17/06, H03K 17/08, H03K 17/18, H03K 17/687

(54) **ANSTEUERUNG EINES ELEKTRISCHEN VERBRAUCHERS**
ACTUATING AN ELECTRIC LOAD
COMMANDE D'UN CONSOMMATEUR ÉLECTRIQUE

(30) Priorität: 13.05.2013 DE 102013208683
(43) Veröffentlichungstag der Anmeldung: 23.03.2016
(73) Patentinhaber: Robert Bosch GmbH, 70442 Stuttgart (DE)
(72) Erfinder: SCHULZE-ICKING-KONERT, Georg, 77830 Buehlertal (DE)
(86) Internationale Anmeldenummer: PCT/EP2014/058573
(87) Internationale Veröffentlichungsnummer: WO 2014/183979

(56) Entgegenhaltungen:
- DE-B3- 10 316 223
- US-A1- 2003 085 750
- US-A1- 2007 058 403
- US-A1- 2008 019 063
- US-A1- 2011 234 185
- US-A1- 2013 107 584

## Beschreibung

Die Erfindung betrifft eine Technik zur Ansteuerung eines elektrischen Verbrauchers. Insbesondere betrifft die Erfindung die Bestimmung einer Degradation einer Stromquelle in einer Ansteuerung des elektrischen Verbrauchers.

### Stand der Technik

Zur Ansteuerung eines elektrischen Verbrauchers, um einen Stromfluss zwischen dem Verbraucher und einem vorbestimmten Potential zu ermöglichen, wird eine Schalteinrichtung verwendet, die mittels einer Treiberschaltung angesteuert wird. Um eine Abwärme gering und eine elektromagnetische Verträglichkeit hoch zu halten, ist es möglich, die Schalteinrichtung zur Steuerung des Verbraucherstroms mit einer Stromquelle statt mit einer Spannungsquelle anzusteuern. Wird die Stromquelle aktiviert, so liefert sie einen vorbestimmten Steuerstrom an die Schalteinrichtung, die in Abhängigkeit des Steuerstroms einen Stromfluss durch den Verbraucher zulässt. Ist die Schalteinrichtung mittels eines Bipolar-Transistors aufgebaut, so kann ein Stromfluss in Abhängigkeit des Steuerstroms analog steuerbar sein, bei einer Ausführungsform mit einem Feldeffekttransistor kann ein anderer Zusammenhang bestehen.

Es ist möglich, dass die Stromquelle auf der Basis einer thermischen Belastung oder eines Alterungseffekts degradiert, das heißt, dass der von ihr bereitgestellte Steuerstrom zu groß oder zu klein ist. Es ist dann zu befürchten, dass die Schalteinrichtung überlastet wird, so dass sie Schaden nehmen kann, oder nicht ausreichend angesteuert wird, so dass sie den Strom durch den Verbraucher zu langsam oder gar nicht ermöglicht. In einer sicherheitskritischen Anwendung, beispielsweise zur Ansteuerung eines Elektromotors als Lenkhilfe in einem Kraftfahrzeug, muss die Ansteuerung bestimmten Zuverlässigkeits- und Sicherheitsanforderungen genügen. Derartige Anforderungen sind beispielsweise in der Spezifikation ASIL (Automotive Safety Integrity Level) entsprechend ISO 26262, festgeschrieben.

Das Dokument US2013/0107584 A1 zu Li et al. offenbart mit Hinweis auf die Figuren 13A und 13B bekannte Schaltungen, wobei eine Gate-Ansteuerung in einem geschlossenen Regelkreis durchgeführt wird. Ein eventueller Fehlerzustand des Gate-Treibers wird dabei nicht ausgewertet.

Es ist Aufgabe der Erfindung, eine Vorrichtung zur Ansteuerung eines elektrischen Verbrauchers, ein Verfahren zum Bestimmen eines Defekts an einer Stromquelle in der Vorrichtung und ein Computerprogrammprodukt bereitzustellen, mit deren Hilfe vorgegebene Zuverlässigkeits- bzw. Sicherheitskriterien eingehalten bzw. verbessert werden können. Die Erfindung löst diese Aufgabe mittels einer Vorrichtung, eines Verfahrens und eines Computerprogrammprodukts mit den Merkmalen der unabhängigen Ansprüche. Unteransprüche geben bevorzugte Ausführungsformen wieder.

### Offenbarung der Erfindung

Eine erfindungsgemäße Vorrichtung zur Ansteuerung eines elektrischen Verbrauchers umfasst eine steuerbare Stromquelle zur Bereitstellung eines Steuerstroms, eine Schalteinrichtung zur Steuerung eines Verbraucherstroms in Abhängigkeit des Steuerstroms und eine Abtasteinrichtung zur Bestimmung einer zeitlichen Verzögerung zwischen dem Aktivieren der Stromquelle und dem Ermöglichen bzw. Unterbrechen eines Stromflusses durch die Schalteinrichtung. Ferner ist eine Verarbeitungseinrichtung vorgesehen, die dazu eingerichtet ist, zu bestimmen, dass die Stromquelle defekt ist, falls die zeitliche Verzögerung außerhalb eines vorbestimmten Bereichs liegt.

Dadurch ist es möglich, frühzeitig zu bestimmen, dass die Stromquelle degradiert, also aufgrund von insbesondere langsamen Veränderungen bzw. Effekten außerhalb ihrer Spezifikation arbeitet, indem der bereitgestellte Steuerstrom zu groß oder zu klein ist. Umfasst die Schalteinrichtung beispielsweise einen Feldeffekttransistor, so muss während eines Einschaltvorgangs zunächst eine Gate-Source-Kapazität aufgeladen werden, dann eine Miller-Kapazität entladen werden und schließlich eine Gate-Source-Kapazität voll aufgeladen werden, um ein vollständiges Durchsteuern des Feldeffekttransistor zu ermöglichen. Stellt die Stromquelle einen zu großen Steuerstrom bereit, so kann der Feldeffekttransistor beim Durchschalten Schaden nehmen. Ist der bereitgestellte Steuerstrom zu gering, so kann das Durchschalten verlangsamt oder unvollständig erfolgen. In beiden Fällen kann eine Funktion eines mit der Schalteinrichtung verbundenen Verbrauchers unter Umständen nicht gewährleistet sein. Die frühzeitige Bestimmung einer Degradation der Stromquelle kann daher dazu beitragen, einen sich anbahnenden Fehler bereits frühzeitig zu erkennen, um ein Fehlersignal auszugeben oder geeignete Gegenmaßnahmen zu treffen. Die Zuverlässigkeit und die Sicherheit der Vorrichtung können dadurch gesteigert sein.

Die Richtung des Steuerstroms ist dabei beliebig, es kann auch ein negativer Steuerstrom bereitgestellt werden, so dass die Stromquelle praktisch als Stromsenke arbeitet. Die Schalteinrichtung kann den Stromfluss in Abhängigkeit des Steuerstroms alternativ ermöglichen oder unterbrechen. Im Folgenden wird exemplarisch von dem Fall einer Stromquelle mit positivem Steuerstrom zum Ermöglichen (Einschalten) eines Stroms durch die Steuereinrichtung ausgegangen.

Umfasst die Schalteinrichtung einen Feldeffekttransistor, so kann die Abtasteinrichtung dazu eingerichtet ist, eine Gate-Source-Spannung des Feldeffekttransistors zu bestimmen. An der Gate-Source-Spannung kann der Grad des Durchschaltens bzw. die Phase des Durchschaltvorgangs abgelesen werden. Ein integrierter Treiber der Vorrichtung kann bereits eine Abtast- bzw. Verarbeitungseinrichtung für die Gate-Source-Spannung umfassen, um beispielsweise eine kurzgeschlossene Schalteinrichtung im Betrieb zu detektieren. So kann eine bereits vorhandene Vorrichtung dazu verwendet werden, den Steuerstrom der Stromquelle über die beschriebene zeitliche Verzögerung zu bestimmen.

Die Abtasteinrichtung kann dabei dazu ausgebildet sein, zu bestimmen, wann die Gate-Source-Spannung die Plateau-Spannung des Feldeffekttransistors überstiegen hat. Wird der Feldeffekttransistor mit dem Steuerstrom beaufschlagt, so steigt die Gate-Source-Spannung zunächst nicht über eine spezifische Plateau-Spannung, bevor die Miller-Kapazität des Feldeffekttransistors entladen ist. Steigt die Gate-Source-Spannung über die Plateauspannung, so wird üblicherweise bereits fast der volle Stromfluss durch die Schalteinrichtung ermöglicht. Dadurch kann eine hinreichend genaue Bestimmung des Zeitpunkts des Ermöglichens des Stromflusses durchgeführt werden.

Umfasst die Schalteinrichtung einen Feldeffekttransistor, so kann in einer alternativen Ausführungsform die Abtasteinrichtung dazu eingerichtet sein, eine Drain-Source-Spannung des Feldeffekttransistors zu bestimmen. Unterschreitet die Drain-Source-Spannung einen vorbestimmten Schwellenwert, so ist der Stromfluss durch die Schalteinrichtung ermöglicht. Überschreitet die Drain-Source-Spannung den Schwellenwert, so ist der Stromfluss durch die Schalteinrichtung sicher unterbrochen. Der Vergleich Drain-Source-Spannung mit dem Schwellenwert kann mittels der Verarbeitungseinrichtung durchgeführt werden.

In einer weiteren Ausführungsform kann ein digitaler Zähler zur Zählung von Impulsen eines Taktsignals zwischen der Ansteuerung der Stromquelle und dem Ermöglichen bzw. Unterbrechen des Stromflusses durch die Schalteinrichtung vorgesehen sein. Der digitale Zähler kann in einer integrierten Steuervorrichtung bereits vorgesehen sein, um zeitliche Abläufe an der Steuervorrichtung untersuchen zu können. So kann die zeitliche Verzögerung auf einfache und effiziente Weise bestimmt werden.

Ein erfindungsgemäßes Verfahren zum Bestimmen eines Defekts an einer Stromquelle zur Bereitstellung eines Steuerstroms für eine Schalteinrichtung umfasst Schritte des Ansteuerns der Stromquelle, des Erfassens einer zeitlichen Verzögerung, bis ein Stromfluss durch die Schalteinrichtung ermöglicht bzw. unterbrochen ist, und des Bestimmens, dass die Stromquelle defekt ist, falls die zeitliche Verzögerung außerhalb eines vorbestimmten Bereichs liegt.

Insbesondere kann bestimmt werden, dass die Stromquelle einen zu großen Steuerstrom bereitstellt, falls die zeitliche Verzögerung unterhalb des vorbestimmten Bereichs liegt. In entsprechender Weise kann bestimmt werden, dass die Stromquelle einen zu kleinen Steuerstrom bereitstellt, falls die zeitliche Verzögerung oberhalb des vorbestimmten Bereichs liegt.

Ein erfindungsgemäßes Computerprogrammprodukt umfasst Programmcodemittel zur Durchführung des beschriebenen Verfahrens, wenn das Computerprogrammprodukt auf einer Verarbeitungseinrichtung abläuft oder auf einem computerlesbaren Datenträger gespeichert ist.

### Kurze Beschreibung der Figuren

Die Erfindung wird nun mit Bezug auf die beigefügten Figuren genauer beschrieben, in denen:
- Figur 1: ein Schaltbild einer Vorrichtung zur Ansteuerung eines Verbrauchers;
- Figur 2: zeitliche Abläufe an einer Schalteinrichtung der Vorrichtung für Figur 1, und
- Figur 3: ein Ablaufdiagramm eines Verfahrens zur Ansteuerung des Verbrauchers mittels der Vorrichtung von Figur 1
darstellt.

### Genaue Beschreibung von Ausführungsbeispielen

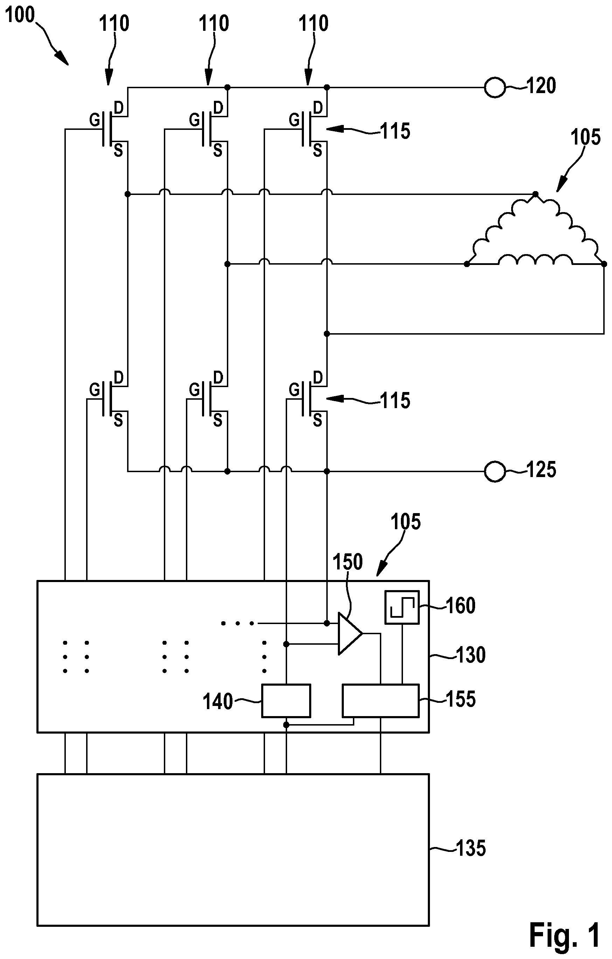

Figur 1 zeigt ein Schaltbild einer Vorrichtung 100 zur Ansteuerung eines Verbrauchers 105. Obwohl die vorgestellte Technik für die Ansteuerung einer beliebigen Anzahl Schalteinrichtungen 115 verwendbar ist, umfasst die in Figur 1 dargestellte Ausführungsform ein etwas komplexeres Beispiel mit drei Halbbrücken 110, die jeweils 2 Schalteinrichtungen 115 umfassen, zur Ansteuerung eines Verbrauchers 105, der hier als Drei-Phasen-Elektromotor in Dreiecksschaltung ausgeführt ist. Die dargestellten Schalteinrichtungen 115 sind exemplarisch jeweils als N-Kanal Feldeffekttransistoren, insbesondere als MOSFETs ausgeführt. In Figur 1 oben dargestellte erste Schalteinrichtungen 115 sind jeweils dazu eingerichtet, einen Stromfluss von einem ersten Potential 120 in den Verbraucher 105, und weiter unten dargestellte, zweite Schalteinrichtungen 115 sind jeweils dazu eingerichtet, einen Strom vom Verbraucher 105 zu einem zweiten Potential 125 zu ermöglichen. Eine erste Schalteinrichtung 115 wird auch als high-side-switch und eine zweite Schalteinrichtung 115 als low-side-switch bezeichnet. In anderen Ausführungsformen ist eine andere Konstellation von Schalteinrichtungen 115 zur Ermöglichung eines Stroms durch den Verbraucher 105 vorgesehen.

Zur Ansteuerung der Schalteinrichtungen 115 ist üblicherweise ein Treiber 130 vorgesehen, der mit den Schalteinrichtungen 115 und/oder einer Verarbeitungsrichtung 135 integriert ausgeführt sein kann. Aus Übersichtlichkeitsgründen sind in Figur 1 Elemente des Treibers 130 nur für eine der Schalteinrichtungen 115 dargestellt, die anderen Schalteinrichtungen 115 können in entsprechender Weise angesteuert sein.

Zur Bereitstellung eines Steuerstroms für die Schalteinrichtung 115 ist eine Stromquelle 140 vorgesehen. Wird die Stromquelle 140 aktiviert, insbesondere durch Steuerung der Verarbeitungseinrichtung 135, so stellt sie einen Steuerstrom an die Schalteinrichtung 115 bereit, woraufhin diese den beschriebenen Stromfluss in den Verbraucher 105 oder aus dem Verbraucher 105 ermöglicht bzw. unterbricht. Um einen Kurzschluss zwischen den Potentialen 120 und 125 zu vermeiden ist darauf zu achten, dass nicht beide Schalteinrichtungen 115 einer Halbbrücke 110 gleichzeitig einen Stromfluss ermöglichen. Die Ansteuerung beider Schalteinrichtungen 115 erfolgt üblicherweise durch die Verarbeitungseinrichtung 135, die sicher stellen muss, dass die Ansteuerungen zeitlich so versetzt sind, dass ein Kurzschluss nicht erfolgt. Nachdem die Schalteinrichtungen 115 auf einen entsprechenden Steuerstrom hin verzögert ein- bzw. ausschalten, können die Ansteuerungen der Stromquellen 140 trotzdem gleichzeitig aktiv sein.

Eine Abtasteinrichtung 145 ist vorgesehen, um eine zeitliche Verzögerung zwischen einem Ansteuern der Stromquelle 140 und dem Ermöglichen bzw. Unterbrechen des Stromflusses durch die Schalteinrichtung 115 zu bestimmen. In der dargestellten Ausführungsform umfasst die Abtasteinrichtung 145 eine Überwachungseinrichtung 150 für die Gate-Source-Spannung der Schalteinrichtung 115. In einer anderen Alternative kann stattdessen auch die Drain-Source-Spannung der Schalteinrichtung 115 mittels der Überwachungseinrichtung 150 überwacht werden. Die Überwachungseinrichtung 150 stellt die abgetastete Spannung oder ein Signal bereit, wenn die abgetastete Spannung einen vorbestimmten Schwellenwert überschritten hat. Im Fall der Gate-Source-Spannung kann dieser Schwellenwert, wie später noch ausführlicher erklärt wird, eine Plateauspannung der Schalteinrichtung 115 sein. Ferner umfasst die Abtasteinrichtung 145 einen Zähler 155, der dazu eingerichtet ist, Impulse eines Taktsignals zu zählen, die von einem Taktgenerator 160 bereitgestellt werden.

Der Zähler 155 ist derart mit der Stromquelle 140 und der Überwachungseinrichtung 150 verbunden, dass das Zählen der Impulse beginnt, wenn die Stromquelle 140 aktiviert wird, und endet, wenn die Überwachungseinrichtung 150 ein Signal bereitstellt, das darauf hinweist, dass der Stromfluss durch die Schalteinrichtung 115 ermöglicht bzw. unterbrochen ist. Der Zählerstand des Zählers 155 ist anschließend ein Hinweis auf die zeitliche Verzögerung zwischen dem Aktivieren der Stromquelle 140 und dem Ermöglichen bzw. Unterbrechen des Stromflusses durch die Schalteinrichtung 115. Diese Verzögerung ist üblicherweise hauptsächlich abhängig von einer Eingangskapazität der Schalteinrichtung 115, insbesondere einer Gate-Kapazität, falls es sich um einen Feldeffekttransistor handelt, einer Einschaltschwelle der Schalteinrichtung 115 und der Stromstärke des durch die Stromquelle 140 bereitgestellten Steuerstroms. Nachdem hauptsächlich der letztgenannte Parameter Alterungs- und Temperatureinflüssen auf die Stromquelle 140 unterbrochen sind, während die anderen Parameter üblicherweise konstant bleiben, kann anhand der bestimmten zeitlichen Verzögerung eine mögliche Degradation der Stromquelle 140 bestimmt werden.

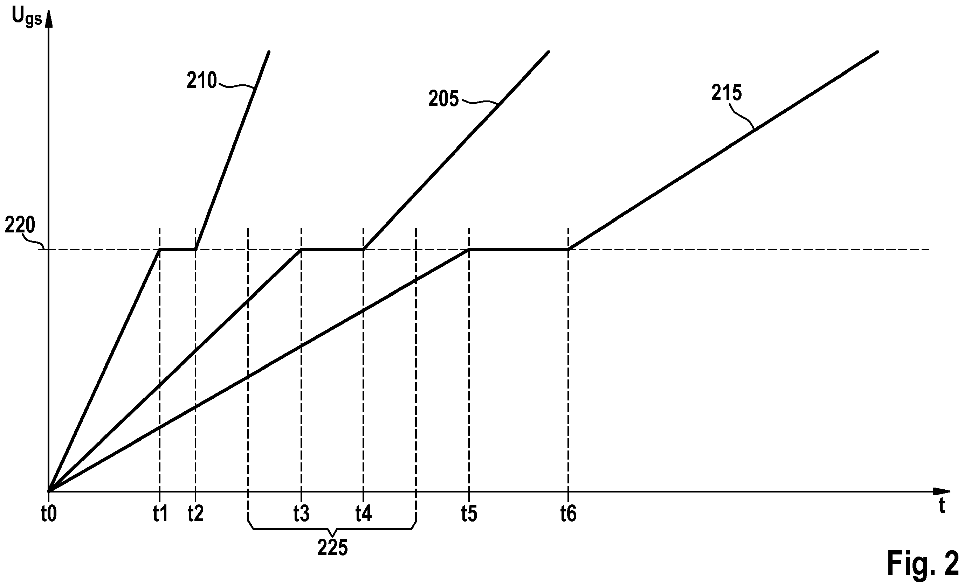

Figur 2 zeigt zeitliche Abläufe an einer Schalteinrichtung 115 der Vorrichtung 100 von Figur 1. In horizontaler Richtung ist eine Zeit und in vertikaler Richtung eine Gate-Source-Spannung eines Feldeffekttransistors angetragen, als der die Schalteinrichtung 115 implementiert ist. Ein erster Ablauf 205 stellt sich ein, wenn die Schalteinrichtung 115 mit dem korrekten Steuerstrom von der Stromquelle 140 beaufschlagt wird. Die Stromquelle 140 wird zu einem Zeitpunkt T0 aktiviert. Von dort an steigt die Gate-Source-Spannung im Wesentlichen linear bis zum Zeitpunkt T3 an, zu dem sie eine Plateauspannung 220 erreicht. Während dieses Intervalls wird die Gate-Source-Kapazität der Schalteinrichtung 115 aufgeladen. Zwischen den Zeitpunkten T3 und T4 wird die Miller-Kapazität der Schalteinrichtung 115 entladen. Während dieser Zeit kann die Gate-Source-Spannung die Plateauspannung 220 nicht übersteigen. Anschließend steigt die Gate-Source-Spannung weiter an, während die Gate-Source-Kapazität fertig aufgeladen wird und die Schalteinrichtung 115 voll durchschaltet.

Ist der Steuerstrom der Stromquelle 140 zu groß, so ergibt sich ein zweiter Ablauf 210. Die Plateauspannung 220 wird bereits zum Zeitpunkt T1 erreicht und zum Zeitpunkt T2 wieder verlassen; das Durchschalten erfolgt beschleunigt. Diese Betriebsweise ist belastend für die Schalteinrichtung 115 und kann zu Defekten führen, außerdem kann eine Abstrahlung von elektromagnetischen Wellen dadurch begünstigt sein, so dass die Vorrichtung unter Umständen eine Anforderung für elektromagnetische Verträglichkeit (EMV) nicht erfüllt. Ist der bereitgestellte Steuerstrom zu gering, so ergibt sich ein dritter Ablauf 215. Hier ist der bereitgestellte Steuerstrom zu gering. Die Plateauspannung 220 wird erst zum Zeitpunkt T5 erreicht und zum Zeitpunkt T6 wieder verlassen. Dadurch kann eine zusätzliche Belastung der Schalteinrichtungen 115 bedingt sein.

Wie bereits oben beschrieben wurde, kann bestimmt werden, dass die Schalteinrichtung 115 einen Stromfluss durch den Verbraucher 105 ermöglicht bzw. unterbricht, wenn die Gate-Source-Spannung die Plateauspannung 220 übersteigt. Die zeitliche Verzögerung zwischen dem Aktivieren der Stromquelle 140 und dem Ermöglichen bzw. Unterbrechen des Stromflusses durch die Schalteinrichtung 115 beträgt beim ersten Ablauf 205 (T4-T0), beim zweiten Ablauf 210 (T2-T0) und beim dritten Ablauf 215 (T6-T0). Es kann nun mit Bezug auf den Zeitpunkt T0 ein zeitlicher Bereich 225 angegeben werden, in dem der Zeitpunkt liegen soll, zu dem die Gate-Source-Spannung die Plateauspannung 220 übersteigt, um den von der Stromquelle 140 bereitgestellten Steuerstrom als korrekt zu bezeichnen. Liegt der genannte Zeitpunkt vor dem Bereich 225, so ist der Steuerstrom zu hoch; liegt er nach dem Bereich 225, so ist er zu gering.

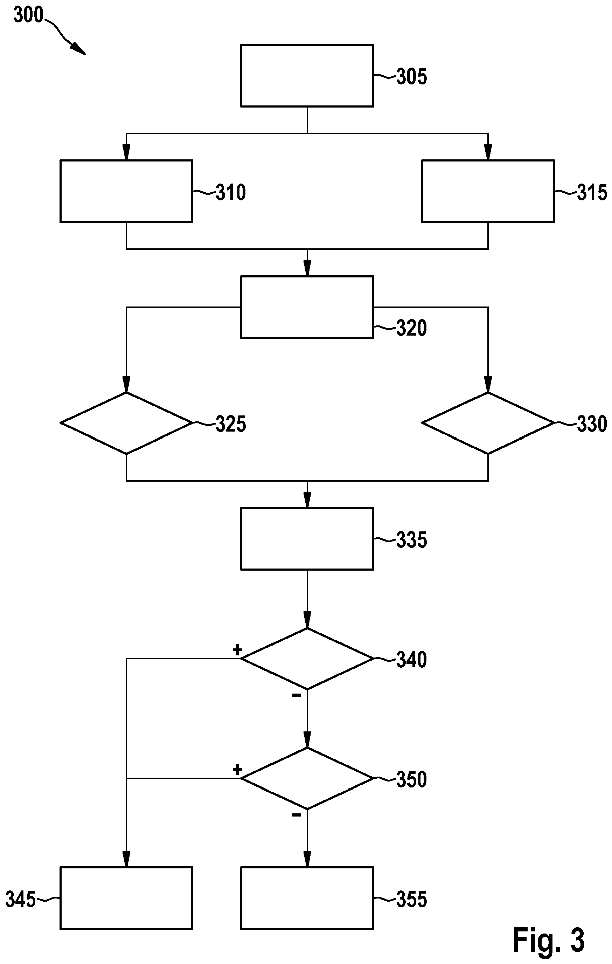

Figur 3 zeigt ein Ablaufdiagramm eines Verfahrens 300 zur Ansteuerung des Verbrauchers 105 mittels der Vorrichtung 100 aus Figur 1. Das Verfahren 300 beginnt in einem Schritt 305. Anschließend werden ein Schritt 310, in dem der Zähler 155 gestartet wird, und ein Schritt 315, in dem die Stromquelle 140 aktiviert wird, möglichst gleichzeitig durchgeführt. Danach wird in einem Schritt 320 bestimmt, ob die Schalteinrichtung 115 den Stromfluss durch den Verbraucher 105 ermöglicht bzw. unterbricht. Handelt es sich bei der Schalteinrichtung 115 um einen Feldeffekttransistor, so kann in einer ersten Variante in einem Schritt 325 bestimmt werden, ob die Gate-Source-Spannung die Plateauspannung 220 übersteigt. In einer zweiten Variante kann in einem Schritt 330 bestimmt werden, ob die Drain-Source-Spannung unterhalb eines vorbestimmten Stellenwerts liegt. Trifft eine der Bedingungen zu, so wird in einem Schritt 335 der Zähler 155 gestoppt. Ausgehend davon, dass der Zähler 155 aufwärts zählt, wird in einem Schritt 340 geprüft, ob der Zählerstand eine obere Grenze übersteigt. Ist dies der Fall, so ist der durch die Stromquelle 140 bereitgestellte Steuerstrom zu klein und in einem Schritt 345 wird eine Degradation der Stromquelle 140 bestimmt. Liegt der Zählerstand unterhalb der oberen Grenze, so kann in einem Schritt 350 bestimmt werden, ob der Zählerstand unterhalb einer unteren Grenze liegt. Ist dies der Fall, so ist der Steuerstrom der Stromquelle 140 zu groß und es wird ebenfalls eine Degradation der Stromquelle 140 im Schritt 345 bestimmt. Andernfalls liegt der Zählerstand zwischen der unteren und der oberen Grenze und in einem Schritt 355 wird bestimmt, dass die Stromquelle 140 nicht degradiert, also nicht defekt ist.

## Patentansprüche

1. Vorrichtung (100) zur Ansteuerung eines elektrischen Verbrauchers (105), wobei die Vorrichtung (100) folgendes umfasst:
- eine steuerbare Stromquelle (140) zur Bereitstellung eines Steuerstroms;
- eine Schalteinrichtung (115) zur Steuerung eines Verbraucherstroms in Abhängigkeit des Steuerstroms,
- eine Abtasteinrichtung (145) zur Bestimmung einer zeitlichen Verzögerung zwischen einer Ansteuerung der Stromquelle (140) und dem Ermöglichen bzw. Unterbrechen eines Stromflusses durch die Schalteinrichtung (115),
**gekennzeichnet durch**
- eine Verarbeitungseinrichtung (135) zur Bestimmung, dass die Stromquelle (140) defekt ist, falls die zeitliche Verzögerung außerhalb eines vorbestimmten Bereichs (225) liegt.

2. Vorrichtung (100) nach Anspruch 1, wobei die Schalteinrichtung (115) einen Feldeffekttransistor umfasst und die Abtasteinrichtung (145) dazu eingerichtet ist, eine Gate-Source-Spannung des Feldeffekttransistors zu bestimmen.

3. Vorrichtung (100) nach Anspruch 2, wobei die Abtasteinrichtung (145) dazu ausgebildet ist, zu bestimmen, wann die Gate-Source-Spannung die Plateau-Spannung (220) des Feldeffekttransistors überstiegen hat.

4. Vorrichtung (100) nach Anspruch 1, wobei die Schalteinrichtung (115) einen Feldeffekttransistor umfasst und die Abtasteinrichtung (145)dazu eingerichtet ist, eine Drain-Source-Spannung des Feldeffekttransistors zu bestimmen.

5. Vorrichtung (100) nach einem der vorangehenden Ansprüche, ferner umfassend einen digitalen Zähler (155) zur Zählung von Impulsen eines Taktsignals (160) zwischen der Ansteuerung der Stromquelle (140) und dem Ermöglichen bzw. Unterbrechen des Stromflusses durch die Schalteinrichtung (115).

6. Verfahren (300) zum Bestimmen eines Defekts an einer Stromquelle (140) zur Bereitstellung eines Steuerstroms für eine Schalteinrichtung (115), wobei das Verfahren (300) folgende Schritte umfasst:
- Ansteuern (315) der Stromquelle;
- Erfassen (335) einer zeitlichen Verzögerung, bis ein Stromfluss durch die Schalteinrichtung (115) ermöglicht bzw. unterbrochen ist;
- Bestimmen (345), dass die Stromquelle (140) defekt ist, falls die zeitliche Verzögerung außerhalb eines vorbestimmten Bereichs (225) liegt.

7. Verfahren (300) nach Anspruch 6, wobei bestimmt wird, dass die Stromquelle (140) einen zu großen Steuerstrom bereitstellt, falls die zeitliche Verzögerung unterhalb des vorbestimmten Bereichs (225) liegt.

8. Verfahren (300) nach Anspruch 6 oder 7, wobei bestimmt wird, dass die Stromquelle (140) einen zu kleinen Steuerstrom bereitstellt, falls die zeitliche Verzögerung oberhalb des vorbestimmten Bereichs (225) liegt.

9. Computerprogrammprodukt mit Programmcodemitteln zur Durchführung des Verfahrens (300) nach einem der vorangehenden Ansprüche, wenn das Computerprogrammprodukt auf einer Verarbeitungseinrichtung (135) abläuft oder auf einem computerlesbaren Datenträger gespeichert ist.

## Claims

1. Apparatus (100) for driving an electrical load (105), wherein the apparatus (100) comprises the following:
- a controllable current source (140) for providing a control current;
- a switching device (115) for controlling a load current depending on the control current,
- a sampling device (145) for determining a time delay between a driving of the current source (140) and the enabling or interruption of a current flow by the switching device (115),
**characterized by**
- a processing device (135) for determining that the current source (140) is defective if the time delay is outside a predetermined range (225).

2. Apparatus (100) according to Claim 1, wherein the switching device (115) comprises a field effect transistor, and the sampling device (145) is designed to determine a gate-source voltage of the field effect transistor.

3. Apparatus (100) according to Claim 2, wherein the sampling device (145) is configured to determine when the gate-source voltage has exceeded the plateau voltage (220) of the field effect transistor.

4. Apparatus (100) according to Claim 1, wherein the switching device (115) comprises a field effect transistor, and the sampling device (145) is designed to determine a drain-source voltage of the field effect transistor.

5. Apparatus (100) according to any of the preceding claims, further comprising a digital counter (155) for counting pulses of any clock signal (160) between the driving of the current source (140) and the enabling or interruption of the current flow by the switching device (115).

6. Method (300) for determining a defect on a current source (140) for providing a control current for a switching device (115), wherein the method (300) comprises the following steps:
- driving (315) the current source;
- detecting (335) a time delay until a current flow is enabled or interrupted by the switching device (115);
- determining (345) that the current source (140) is defective if the time delay is outside a predetermined range (225).

7. Method (300) according to Claim 6, wherein it is determined that the current source (140) provides an excessively large control current if the time delay is below the predetermined range (225).

8. Method (300) according to Claim 6 or 7, wherein it is determined that the current source (140) provides an excessively small control current if the time delay is above the predetermined range (225).

9. Computer program product comprising program code means for carrying out the method (300) according to one of the preceding claims when the computer program product runs on a processing device (135) or is stored on a computer-readable data carrier.

## Revendications

1. Dispositif (100) pour commander un consommateur électrique (105), le dispositif (100) comprenant les éléments suivantes :
- une source de courant (140) commandable destinée à délivrer un courant de commande ;
- un appareil de commutation (115) destiné à commander un courant de consommateur en fonction du courant de commande,
- un appareil d'échantillonnage (145) destiné à déterminer un retard dans le temps entre une commande de la source de courant (140) et la libération ou l'interruption d'un flux de courant à travers l'appareil de commutation (115),
**caractérisé par**
- un appareil de traitement (135) destiné à déterminer que la source de courant (140) est défectueuse dans le cas où le retard dans le temps se trouve en-dehors d'une plage prédéfinie (225).

2. Dispositif (100) selon la revendication 1, l'appareil de commutation (115) comprenant un transistor à effet de champ et l'appareil d'échantillonnage (145) étant conçu pour déterminer une tension gâchette-source du transistor à effet de champ.

3. Dispositif (100) selon la revendication 2, l'appareil d'échantillonnage (145) étant conçu pour déterminer à quel moment la tension gâchette-source a dépassé la tension de plateau (220) du transistor à effet de champ.

4. Dispositif (100) selon la revendication 1, l'appareil de commutation (115) comprenant un transistor à effet de champ et l'appareil d'échantillonnage (145) étant conçu pour déterminer une tension drain-source du transistor à effet de champ.

5. Dispositif (100) selon l'une des revendications précédentes, comprenant en outre un compteur numérique (155) destiné à compter les impulsions d'un signal cyclique (160) entre la commande de la source de courant (140) et la libération ou l'interruption du flux de courant à travers l'appareil de commutation (115).

6. Procédé (300) pour déterminer un défaut au niveau d'une source de courant (140) destinée à délivrer un courant de commande pour un appareil de commutation (115), le procédé (300) comprenant les étapes suivantes :
- commande (315) de la source de courant ;
- détection (335) d'un retard dans le temps jusqu'à ce qu'un flux de courant à travers l'appareil de commutation (115) soit libéré ou interrompu ;
- détermination (345) que la source de courant (140) est défectueuse si le retard dans le temps se trouve en-dehors d'une plage prédéfinie (225).

7. Procédé (300) selon la revendication 6, la fourniture par la source de courant (140) d'un courant de commande trop élevé étant déterminée dans le cas où le retard dans le temps se trouve au-dessous de la plage prédéfinie (225).

8. Procédé (300) selon la revendication 6 ou 7, la fourniture par la source de courant (140) d'un courant de commande trop faible étant déterminée dans le cas où le retard dans le temps se trouve au-dessus de la plage prédéfinie (225).

9. Produit de programme informatique comprenant des moyens de code programme destinés à mettre en oeuvre le procédé (300) selon l'une des revendications précédentes lorsque le produit de programme informatique est exécuté sur un appareil de traitement (135) ou est enregistré sur un support de données lisible par ordinateur.
